# EUROPÄISCHE PATENTANMELDUNG

(11) **EP 0 865 183 A2**
(43) Veröffentlichungstag der Anmeldung: **16.09.1998**
(21) Anmeldenummer: 98102808.7
(22) Anmeldetag: 18.02.1998
(51) Int. Cl.: H04M 1/02

(54) **Gehäuse eines Telekommunikations-Gerätes**

(30) Priorität: 14.03.1997 DE 19710735; 14.03.1997 DE 29712693 U
(71) Anmelder: QUANTE AG, 42109 Wuppertal (DE)
(72) Erfinder: Bund, Christine, 42111 Wuppertal (DE); Trenkmann, Björn, 44829 Bochum (DE); Anders, Herbert, 44309 Dortmund (DE); Denter, Friedrich, 44575 Castrop-Rauxel (DE)
(74) Vertreter: Füchsle, Klaus, Dipl.-Ing.

(57) **Zusammenfassung**

Ein Gehäuse (10) eines Telekommunikations-, insbesondere ISDN-Netzabschlußgerätes, wie NTBA, weist einen Gerätestecker (18) zum Einstecken einer Gerätesteckdose (46) und eine Klemmeinrichtung (20) für die Gerätesteckdose (46) und/oder ein daran angeschlossenes Kabel auf.

## Beschreibung

### Technisches Gebiet

Die Erfindung betrifft ein Gehäuse eines Telekommunikations-Gerätes für einen ISDN-Basisanschluß (ISDN-Netzabschlußgerät).

Bei der Einrichtung eines Telefonanschlusses als ISDN-Anschluß ist es erforderlich, daß an das zu dem Teilnehmer führende Fernmeldeinstallationskabel ein ISDN-Netzabschlußgerät, eine sogenannte NTBA, angeschlossen wird. An die NTBA werden dann die einzelnen Geräte, wie z.B. Telefone, Faxgerät, PC, oder eine Telefonanlage angeschlossen. Um die genannten Anschlußmöglichkeiten zu gewährleisten, ist bei einem derartigen Netzabschlußgerät zum einen ein sogenannter Installationsraum vorgesehen, in dem sich ein Arischlußklemme befindet, an den das Fernmeldeinstallationskabel anzuschließen ist, und der nur für autorisierte Personen, beispielsweise Installateure, zugänglich sein soll. Zum anderen sind in dem Gehäuse Öffnungen vorgesehen, durch welche die genannten Endgeräte in entsprechende, in dem Gehäuse angeordnete Steckbuchsen eingesteckt werden können. Schließlich benötigen die ISDN-Netzabschlußgeräte je nach Anforderung optional eine 230 V Versorgung, für die ein entsprechendes Kabel vorzusehen ist, das in eine Standard-Netzsteckdose eingesteckt wird.

### Stand der Technik

Bei den bekannten NTBA-Gehäusen ist ein eigener, vergleichsweise kleiner Deckel vorgesehen, der den Installationsraum abdeckt und über eine Öse mit einer Plombe versehen werden kann, so daß ein unberechtigter Zugang erkannt werden kann. Die notwendigerweise außen am Gehäuse und deshalb sichtbar angebrachte Plombe stört jedoch die Optik der bekannten NTBA-Gehäuse. Ferner besteht die Gefahr, daß die Plombe, die in einem Bereich angeordnet ist, in dem häufig Kabel eingesteckt und gezogen werden, bei diesen Vorgängen beschädigt wird.

Darüber hinaus ist es für die bekannten Netzabschlußgeräte wünschenswert, daß diese nicht ein direkt an einem Trafo in dem Gehäuse angeschlossenes Netzkabel aufweisen, sondern daß in dem Gehäuse ein Gerätestecker für eine Gerätesteckdose mit einem Kabel vorgesehen ist, an dessen anderem Ende sich der Stecker für die Einführung in die Steckdose (230 V) befindet. Die bekannten NTBA-Gehäuse sind jedoch nicht ohne weiteres so umzugestalten, daß die Anordnung eines Gerätesteckers in dem Gehäuse ermöglicht wird, und gleichzeitig hinreichend Raum für die Handhabung der einzuführenden Gerätesteckdose vorhanden ist. Ferner ist bei einem in dieser Weise modifizierten Gehäuse ein sicherer Verbleib der Gerätesteckdose in dem Gerätestecker nicht ohne weiteres zu gewährleisten.

### Darstellung der Erfindung

In Anbetracht der beschriebenen Nachteile und ungelösten Probleme bei bekannten Gehäusen von ISDN-Netzabschlußgeräten liegt der Erfindung die Aufgabe zugrunde, ein Gehäuse für ein Telekommunikations-Netzabschlußgerät zu schaffen, in dem ein Gerätestecker für eine Gerätesteckdose aufgenommen ist, und das optisch ansprechend, insbesondere kompakt und insgesamt funktionell gestaltet ist.

Die Lösung dieser Aufgabe erfolgt durch ein Gehäuse gemäß dem Anspruch 1.

Demzufolge weist für die Zuverlässigkeit der Steckverbindung zwischen einer eingeführten Gerätesteckdose und dem Gerätestecker das Gehäuse eine Klemmeinrichtung zur Klemmung der Gerätesteckdose und/oder des an der Gerätesteckdose angeschlossenen Kabels auf. Hierdurch kann eine Zugentlastung ausgebildet werden, die auch bei dem Auftreten von Zugkräften auf das aus dem Gehäuse herausgeführte Netzkabel (z.B. 230 V) ein Herausziehen der Gerätesteckdose aus dem Gerätestecker verhindert, was die Versorgung der NTBA mit dem Netzstrom unterbrechen würde, und in bestimmten Anwendungsfällen die an die NTBA angeschlossenen Geräte außer Funktion setzen würde.

Vorteilhafte Ausführungsformen des erfindungsgemäßen Gehäuses sind in den weiteren Ansprüchen beschrieben.

Gemäß einer Ausführungsform ist die vorangehend beschriebene Klemmeinrichtung durch mehrere Stifte und/oder Rippen gebildet, durch die zur Klemmung des Netzkabels ein Labyrinth ausgebildet wird.

Für die Klemmeinrichtung wird bevorzugt, daß diese ein Schiebeelement aufweist, das in eine Stellung verschiebbar ist, in der es das Netzkabel oder einen Abschnitt der in den Gerätestecker eingeführten Gerätesteckdose klemmt oder verriegelt.

Wenn die Klemmeinrichtung gemäß einer alternativen Ausführungsform im Bereich des Randes des erfindungsgemäßen Gehäuses ausgebildet ist, wird zwischen der Klemmeinrichtung und dem Gerätestecker ein maximaler Raum ausgebildet, der auch bei einem Verbleib des Kabels in der Klemmeinrichtung ein Ein- und Ausstecken der Gerätesteckdose zum Rangieren ermöglicht.

Gemäß einer bevorzugten Ausführungsform der Klemmeinrichtung ist diese an einem Grundgehäuse des Gehäuses ausgebildet.

Alternativ kann es in besonderen Anwendungsfällen Vorteile bieten, wenn die Klemmeinrichtung an einem zweiten Deckel des Gehäuses ausgebildet ist.

Zu der vorangehend beschriebenen Klemmeinrichtung und deren verschiedenen Ausführungsformen ist festzustellen, daß die dadurch erreichbaren Vorteile grundsätzlich von den übrigen Merkmalen des erfindungsgemäßen Gehäuses eines ISDN-Netzabschlußgerätes unabhängig sind. Immer wenn ein derartiges ISDN-Netzabschlußgerät, beispielsweise eine NTBA, mit einem Gerätestecker zum Einstecken einer Gerätesteckdose versehen ist, ist es vorteilhaft, die vorangehend beschriebene Klemmeinrichtung in einer geeigneten Ausführungsform auszubilden. Hierfür muß das entsprechende Gehäuse somit nicht notwendigerweise den erfindungsgemäßen zweiten Deckel zur Abdeckung der Gerätesteckdose und des Bereichs des Anschlußblocks, oder sonstige vorangehend beschriebene neuartige Merkmale aufweisen.

Bevorzugt weist das erfindungsgemäße Gehäuse zum einen ein Grundgehäuse auf, in dem elektrische Bauteile sowie ein Gerätestecker für eine Gerätesteckdose und gegebenenfalls weitere Komponenten untergebracht sind. Das Grundgehäuse ist so gestaltet, daß der Gerätestecker und eine Anschlußklemme (nachfolgend auch als Anschlußblock bezeichnet) für den Anschluß eines Fernmeldeinstallationskabels frei zugänglich sind. Durch diese Ausbildung des Gehäuses kann in vorteilhafter Weise gewährleistet werden, daß die für den Benutzer bzw. den Installateur zugänglichen Bereiche, nämlich der Gerätestecker für die Gerätesteckdose und der Anschlußblock für das Fernmeldeinstallationskabel, zugänglich sind, während die auch während der Installation und der Montage zu schützenden Komponenten des Netzabschlußgerätes in dem Gehäuse untergebracht und vor einem Zugriff geschützt sind.

Ferner ist bei dem beschriebenen Gehäuse ein erster Deckel vorhanden, der im angebrachten Zustand den Bereich des Anschlußblocks für das Fernmeldeinstallationskabel abdeckt und mit einer Sicherungseinrichtung versehen ist. Hierdurch wird für diesen Bereich eine begrenzte Zugänglichkeit gewährleistet. Insbesondere kann der Anschlußblock für das Fernmeldeinstallationskabel durch den genannten Deckel verschlossen und durch eine geeignete Sicherheitseinrichtung gegen einen unerlaubten Zugriff gesichert werden, während beispielsweise der Bereich des Gerätesteckers für die 230 V-Gerätesteckdose weiterhin zugänglich ist.

Schließlich weist dieses Gehäuse bevorzugt einen zweiten Deckel auf, der im angebrachten Zustand den mit dem ersten Deckel verschlossenen Bereich der Anschlußklemme und eine in den Gerätestecker eingeführte Gerätesteckdose zumindest teilweise abdeckt. Durch diesen zweiten Deckel können im angebrachten Zustand auch die vorangehend beschriebenen Bereiche gegen Staub geschützt werden. Ferner werden diese Bereiche einschließlich der nunmehr einführ- und ansteckbaren Gerätesteckdose und der Sicherungseinrichtung, beispielsweise der Plombe, für ein optisch ansprechendes Erscheinungsbild des zusammengesetzten Gehäuses vollständig abgedeckt. Dadurch erscheint das erfindungsgemäße Gehäuse im zusammengesetzten Zustand als ein kompaktes Gehäuse ohne herausragende oder vorstehende Elemente. Ferner ist das Gehäuse äußerst klein ausführbar und weist mit Ausnahme der beiden Deckel keine beweglichen oder verlierbaren Teile auf. Gleichzeitig wird durch die beschriebene Zugänglichkeit einzelner Bereiche die Funktionalität gewährleistet.

Für das Gehäuse gestaltet sich der Zusammenbau vorteilhaft, wenn dieses zweiteilig ausgeführt ist und insbesondere aus einem Ober- und einem Unterteil besteht, die rastbar miteinander verbunden sind.

Besondere Vorteile hinsichtlich der Kompaktheit des Gehäuses und der Funktionalität bei der Installation ergeben sich, wenn das Grundgehäuse im Bereich zwischen dem Gerätestecker und dem Außenrand des Gehäuses derart ausgespart ist, daß eine Handhabung der Gerätesteckdose im Bereich des Gerätesteckers ermöglicht wird. Durch diese Maßnahme wird bei dem erfindungsgemäßen Gehäuse ein wesentliches Problem gelöst, das sich bei der Ausbildung eines Gerätesteckers für eine Gerätesteckdose in einer NTBA ergibt. Die Platzverhältnisse sind nämlich ohnehin relativ beengt, und die Anbringung der Gerätesteckdose benötigt insbesondere einen Rangierraum, wenn dieser aus optischen Gründen innerhalb des zusammengesetzten Gehäuses untergebracht sein soll. Diese Konflikte zwischen den Anforderungen an das optische Erscheinungsbild und dem Platzbedarf für die Gerätesteckdose werden gemäß der beschriebenen Ausführungsform dadurch gelöst, daß das Grundgehäuse in dem genannten Bereich eine Aussparung aufweist, die die Gerätesteckdose aufnimmt und ferner ein Rangieren, ein Einund Ausstecken der Gerätesteckdose mit wenig Mühe ermöglicht. Nach Anbringung des zweiten Deckels wird auch die genannte Aussparung abgedeckt, so daß den Anforderungen an die Optik Genüge getan ist.

Für die Sicherungseinrichtung des ersten Deckels ist es vorteilhaft, wenn dieser eine Öse aufweist, und wenn ferner das Grundgehäuse im Bereich des ersten Deckels eine Öse aufweist, wobei die beiden Ösen und eine daran anbringbare Plombe durch den zweiten Deckel abdeckbar sind. Hierdurch kann die eingeschränkte und sicherbare Zugänglichkeit des sogenannten Fernmelde-Installationsraumes, also des Bereichs des Anschlußblocks für den Anschluß eines Fernmeldeinstallationskabels, in bewährter Weise beispielsweise durch eine Plombe gesichert werden. Im Unterschied zu den bekannten NTBAs ist diese Plombe jedoch nicht außen an dem fertig zusammengesetzten Gehäuse sichtbar, sondern wird in optisch ansprechender Weise durch den zweiten Deckel abgedeckt. Falls dies erwünscht oder erforderlich ist, kann der durch die Ösen geführte Draht auch hinreichend lang ausgebildet werden, so daß er aus dem Gehäuse herausgeführt und außerhalb des Gehäuses mit der Plombe versehen werden kann.

Für die Funktionalität, insbesondere bei der Installation der verschiedenen Kabel an der erfindungsgemäßen NTBA, bietet es Vorteile, wenn der zweite Deckel für die Herausführung des Netzkabels und des Fernmeldeinstallationskabels derart ausgespart ist, daß diese an voneinander beabstandeten Stellen aus dem Gehäuse herausführbar sind. Hierdurch können eine unzweckmäßige Überlagerung und dadurch verursachte Unübersichtlichkeiten vermieden werden.

Für das optische Erscheinungsbild des erfindungsgemäßen Gehäuses ist es außerdem von Vorteil, wenn dieses in seiner Rückwand eine Kabeldurchführung aufweist, die entweder in einer Öffnung bestehen kann oder durch einen Abschnitt gebildet wird, der durch Sollbruchstellen umgeben ist, so daß eine Öffnung ausgebildet werden kann. Durch eine derartige Kabeldurchführung kann das Fernmeldeinstallationskabel durch die Rückwand in das Gehäuse eingeführt werden und muß somit nicht in unschöner Weise über die Wand in die Umgebung der NTBA geführt werden.

In vorteilhafter Weise kann das erfindungsgemäße Gehäuse ferner so gestaltet werden, daß es unmittelbar auf einer Unterputzdose anbringbar ist. Dies kann beispielsweise dadurch gewährleistet werden, daß in der Rückwand eine weitere Öffnung ausgebildet ist, über die das Gehäuse mittels der Befestigungsschrauben einer Unterputzdose unmittelbar auf der Unterputzdose montiert werden kann. Hierbei bieten ein oder mehrere Langlöcher, z.B. mit einem verbreiterten Abschnitt, die vorzugsweise auf einem gedachten Kreis angeordnet sein können, besondere Vorteile. Bei entsprechender Beabstandung der Langlöcher können die ein wenig herausgedrehten Befestigungsschrauben der Unterputzdose durch die verbreiterten Abschnitte geführt werden, und nach einem Verschieben des Gehäuses können die Schrauben zur sicheren Befestigung des Gehäuses unmittelbar auf der Unterputzdose in den schmaleren Abschnitten der Öffnungen festgezogen werden.

### Kurze Beschreibung der Zeichnungen

Nachfolgend wird die Erfindung anhand von beispielhaft in den Zeichnungen dargestellten Ausführungsformen näher beschrieben. Es zeigen:
- Fig. 1: eine perspektivische Ansicht des Grundgehäuses mit einem angeschlossenen Fernmeldeinstallationskabel;
- Fig. 2: eine perspektivische Ansicht der beiden Deckel;
- Fig. 3: eine Draufsicht des Grundgehäuses;
- Fig. 4: eine Querschnittsansicht des Grundgehäuses in einer anderen Ausführungsform;
- Fig. 5: eine perspektivische Ansicht eines Teils eines erfindungsgemäßen Gehäuses mit einer anderen Ausführungsform der Kabelklemmeinrichtung; und
- Fig. 6: eine Teilschnittansicht des in Fig. 5 gezeigten Gehäuses.

### Beschreibung von Ausführungsbeispielen der Erfindung

Wie vorangehend beschrieben, wird das erfindungsgemäße Gehäuse 10 durch ein Grundgehäuse 12 und zwei Deckel 14 und 16 gebildet.

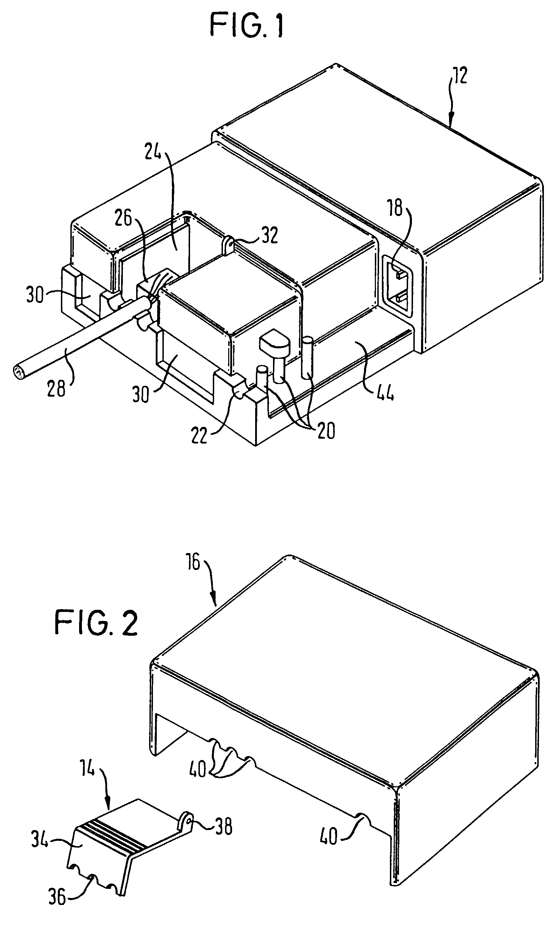

Wie an dem in Fig. 1 dargestellten Grundgehäuse 12 zu erkennen ist, ist dieses so gestaltet, daß wesentliche Teile des ISDN-Netzabschlußgerätes in diesem aufgenommen sind, während verschiedene Abschnitte und Steckbuchsen zugänglich sind. Hierbei handelt es sich zum einen um den in Fig. 1 im rechten Bereich des Grundgehäuses sichtbaren Gerätestecker 18, welcher der Einführung einer (nicht gezeigten) 230 V-Gerätesteckdose dient. Für die Aufnahme der Gerätesteckdose ist das Grundgehäuse 12 so gestaltet, daß es im Bereich zwischen dem Gerätestecker 18 und den Rändern des Grundgehäuses 12 ausgespart oder abgesenkt ist.

Im Bereich des vorderen Randes des Grundgehäuses 12 ist eine Klemmeinrichtung zur Klemmung des Netzkabels ausgebildet, die durch z.B. mehrere Stifte 20 (oder Konturen) gebildet wird, die in Richtung des Kabelverlaufs (das von dem Gerätestecker 18 zu der am vorderen Rand ausgebildeten Ausnehmung 22 geführt wird) sowie seitlich zum Verlauf des Kabels versetzt angeordnet sind. Hierdurch kann das Netzkabel derart schlangenlinienförmig durch die Stifte 20 (oder Kanten) geführt werden und zwischen diesen verklemmt werden, daß durch den Reibungseingriff jegliche Zugkräfte, die auf ein eingeführtes Kabel aufgebracht werden, von den Stiften aufgenommen werden, so daß verhindert wird, daß die Gerätesteckdose aus dem Gerätestecker 18 gezogen wird.

Im vorderen Bereich des Grundgehäuses 12, links von der Mitte des Grundgehäuses 12 ist der sogenannte Fernmelde-Installationsraum 24 ausgebildet. In diesem Bereich ist das Grundgehäuse 12 derart ausgespart, daß eine Anschlußklemme 26 zugänglich ist, der auf einer (in Fig. 1 nicht sichtbaren) Leiterplatte angebracht ist, die im übrigen vollständig (außer im Bereich des Installationsraumes) von dem Grundgehäuse 12 abgedeckt und geschützt wird. Im Rahmen der Installation des gezeigten ISDN-Netzabschlußgerätes wird ein Fernmeldeinstallationskabel 28 an die Anschlußklemme 26 angeschlossen. Die Zugänglichkeit der Anschlußklemme 26 ist jedoch nur für die Dauer dieser Installationsarbeiten erforderlich und erwünscht. Für den Verschluß und die Sicherung dieses Bereichs gegen unerlaubten Zugriff dient der nachfolgend beschriebene und in Fig. 2 gezeigte erste Deckel 14. Für die Sicherung des Installationsraumes 24 dient ferner die an dem Grundgehäuse ausgebildete Öse 32.

Im Zusammenhang mit der Fig. 1 ist noch zu ergänzen, daß im vorderen Bereich des Grundgehäuses 12 verschiedene Steckbuchsen 30 ausgebildet sind, die ebenfalls auf der (nicht sichtbaren) Leiterplatte angebracht sind und dem Anschluß von Endgeräten, wie z.B. Telefonen, Faxgeräten und Computern dienen. Diese können z.B. als Westernsteckbuchsen, gegebenenfalls codiert ausgeführt sein.

In Fig. 2 ist zum einen der erste Deckel 14 zu erkennen, der für die Abdeckung und die Sicherung des Installationsraumes 24 bestimmt ist. Dieser Deckel 14 ist weitgehend L-förmig gestaltet und weist an seinem kürzeren, vorderen Schenkel 34 mehrere, in dem gezeigten Ausführungsbeispiel halbkreisförmige Ausnehmungen 36 auf, die zusammen mit entsprechenden Ausnehmungen in dem Grundgehäuse 12 Kabeldurchführungen für das Fernmeldeinstallationskabel 28 festlegen. Am hinteren rechten Ende ist bei dem gezeigten Ausführungsbeispiel des ersten Deckels 14 eine Öse 38 ausgebildet, die bei der Anbringung des Deckels 14 an dem Grundgehäuse 12 im Bereich der Öse 32 des Grundgehäuses 12 angeordnet ist. Zur Sicherung des Installationsraumes 24 gegen unerlaubten Zugriff wird durch die beiden Ösen ein Draht geführt, der nachfolgend plombiert wird. Diese Plombe befindet sich bei den bekannten NTBA-Gehäusen in optisch störender Weise außerhalb des Gehäuses.

Durch den ebenfalls in Fig. 2 gezeigten sogenannten zweiten Deckel 16 wird bei dem erfindungsgemäßen Gehäuse 10 neben einer in den Gerätestecker 18 eingeführten Gerätesteckdose auch die Plombierung an den Ösen 32, 38 abgedeckt. Im vorderen Bereich des Deckels 16 sind Ausnehmungen 40 zu erkennen, die, wie vorangehend für den ersten Deckel 14 beschrieben, zusammen mit entsprechenden Ausnehmungen in dem Gehäuse 12 Kabeldurchführungen für das Fernmeldeinstallationskabel 28 und darüber hinaus, mit der Ausnehmung 22 zusammenwirkend, eine Durchführung für das Netzkabel festlegen. Wie aus den Fig. 1 und 2 ohne weiteres ersichtlich ist, sind nach der Abdeckung der bei dem Grundgehäuse 12 freiliegenden Installationsräume durch den Deckel 16 lediglich das Fernmeldeinstallationskabel 28, das (nicht gezeigte) Netzkabel sowie die an den Steckbuchsen 30 angeschlossenen Kabel aus dem Gehäuse herausgeführt. Ansonsten stellt sich das erfindungsgemäße Gehäuse als kompakte, optisch ansprechende Einheit dar.

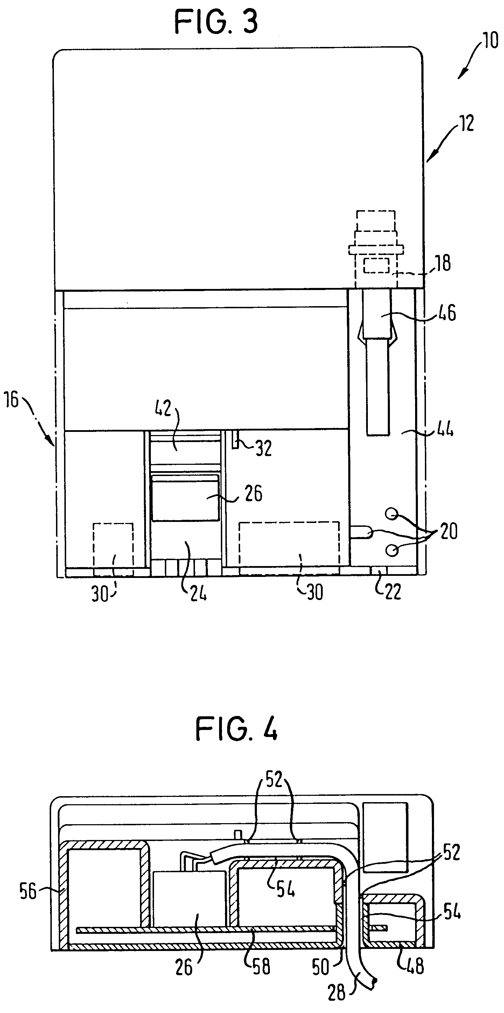

Das kompakte Erscheinungsbild wird auch aus der Draufsicht von Fig. 3 deutlich, in der die Außenränder des Gesamtgehäuses im Bereich des aufgesetzten Deckels 16 mit Strichpunktlinien dargestellt sind. Aus der Draufsicht von Fig. 3 wird ferner deutlich, daß sich der Deckel 16 im wesentlichen über die gesamte vordere Hälfte des Gehäuses 10 erstreckt. In diesem Bereich sind bei abgenommenem Deckel der Installationsraum 24 mit dem Anschlußblock 26 und einem dahinter angeordneten Kippschalter 42 freigelegt. Seitlich davon befindet sich die Öse 32 zur Anbringung der Sicherungseinrichtung. Im vorderen Bereich sind ferner die unter den entsprechenden Abschnitten des Grundgehäuses 12 angeordneten Steckbuchsen 30 dargestellt.

Im rechten vorderen Bereich des Grundgehäuses 12 ist der Rangierraum 44 für die in den Gerätestecker 18 eingeführte Gerätesteckdose 46 zu erkennen. Dieser Rangierraum 44 wird durch den Bereich zwischen dem Gerätestecker 18 und den Stiften 20 gebildet, die der Klemmung des (nicht dargestellten) Netzkabels dienen.

Im übrigen ist in Fig. 3 eine Ausführungsform des erfindungsgemäßen Gehäuses dargestellt, bei der, in Übereinstimmung mit Fig. 1, das Fernmeldeinstallationskabel nach vorne, also gemäß der Ausrichtung von Fig. 3 nach unten, herausgeführt wird.

Im Gegensatz dazu zeigt Fig. 4 einen Schnitt durch ein Grundgehäuse in einer anderen Ausführungsform, bei dem die Einführung des Fernmeldeinstallationskabels 28 von unten erfolgt. Wie in Fig. 4 zu erkennen ist, ist hierzu im Unterteil 48 des Grundgehäuses 12 eine Öffnung 50 ausgebildet. Durch diese Öffnung 50 wird das Fernmeldeinstallationskabel 28 gewissermaßen durch die Unterseite des Gehäuses zu der Oberseite des Grundgehäuses geführt, wobei in den entsprechenden Abschnitten des Grundgehäuses 12 Klemmeinrichtungen 52 ausgebildet sein können, die eine Zugentlastung für das Fernmeldeinstallationskabel 28 bewirken. Durch einen zunächst senkrecht und daran anschließend parallel zu der Unterseite des Gehäuses verlaufenden Kanal 54 wird das Fernmeldeinstallationskabel 28 zu dem Anschlußblock 26 geführt, an dem es im Rahmen der Installation anzuschließen ist. Durch diese Art der Einführung des Fernmeldeinstallationskabels 28 kann die Optik des erfindungsgemäßen Gehäuses weiter verbessert werden, indem das Kabel nicht nach außen in Erscheinung tritt, sondern von einer Unterputzdose direkt in das Gehäuse geführt wird.

Aus der Schnittdarstellung von Fig. 4 ist ferner zu erkennen, daß das Oberteil 56 des Grundgehäuses 12 derart gestaltet ist, daß es einzelne Bereiche der in dem Gehäuse befindlichen Leiterplatte 58 sowie darauf angebrachte (nicht gezeigte) elektrische Bauteile abdeckt, während der Zugang zu dem Anschlußblock 26 freigelegt ist. Der Bereich des Anschlußblocks 26 wird erst nach dem Anschließen des Fernmeldeinstallationskabels 28 durch den Deckel 14 abgedeckt.

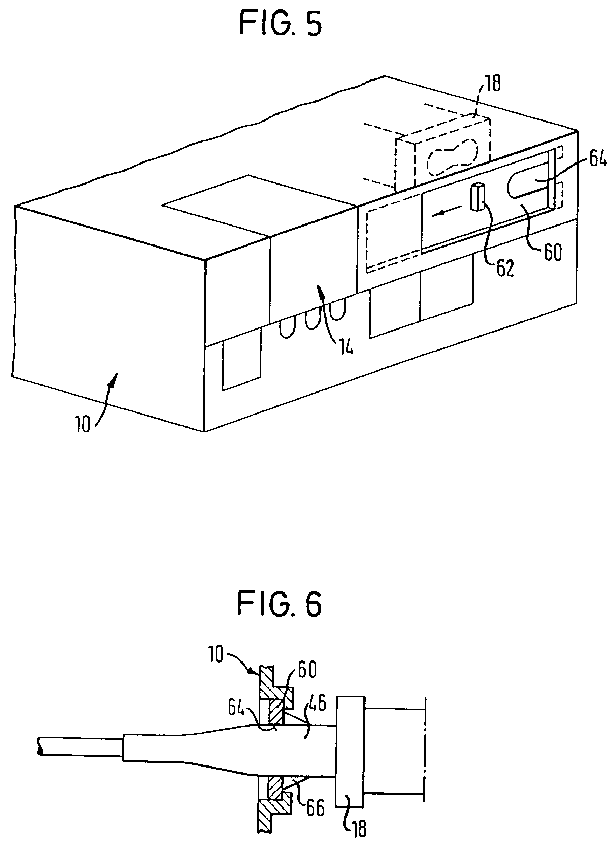

In Fig. 5 ist eine alternative Ausführungsform einer Klemmeinrichtung für das Netzkabel dargestellt. An dem gezeigten Gehäuse 10 ist im vorderen Bereich neben der Abdeckung 14 für den Installationsraum ein Schiebeelement 60 zu erkennen, das mit Hilfe eines kleinen Griffs 62 nach rechts und links verschoben werden kann. In dem gezeigten Fall ist im rechten Bereich des Schiebeelements 60 eine längliche, abgerundete Aussparung 64 ausgebildet, die der Durchführung eines (nicht gezeigten) Kabels oder eines Abschnitts der Gerätesteckdose dient, der in den Gerätestecker 18 einzuführen ist. Hierdurch wird eine Klemmung der Gerätesteckdose oder des Kabels erreicht, die im wesentlichen von der speziellen Ausbildung der sonstigen Gehäuseteile unabhängig ist.

Wie in der Schnittdarstellung des Bereichs der Durchführung der Gerätesteckdose in Fig. 6 zu erkennen ist, wird das Schiebeelement 60 in den daran angrenzenden Abschnitten des Gehäuses 10 geführt. Die Gerätesteckdose 46, die in den Gerätestecker 18 eingeführt wird, kann mit sogenannten Schultern 66 versehen sein, die mit den Bereichen in der Umgebung der Aussparung 64 in Eingriff stehen, so daß die Gerätesteckdose nicht aus dem Gerätestecker 18 (gemäß der Darstellung von Fig. 6 nach links) gezogen werden kann.

## Patentansprüche

1. Gehäuse (10) eines Telekommunikations-, insbesondere ISDN-Netzabschlußgerätes, wie NTBA, mit einem Gerätestecker (18) zum Einstecken einer Gerätesteckdose (46) und einer Klemmeinrichtung (20, 60) für die Gerätesteckdose (46) und/oder ein daran angeschlossenes Kabel.

2. Gehäuse nach Anspruch 1,
dadurch **gekennzeichnet,** daß
die Klemmeinrichtung durch mehrere Stifte (20) oder Rippen gebildet wird, die ein Labyrinth zur Klemmung des Kabels ausbilden.

3. Gehäuse nach Anspruch 1,
dadurch **gekennzeichnet,** daß
die Klemmeinrichtung durch ein Schiebeelement (60) gebildet wird, das in eine Stellung verschiebbar ist, in der das Kabel und/oder ein Abschnitt der Gerätesteckdose (46) geklemmt wird.

4. Gehäuse nach zumindest einem der Ansprüche 1 bis 3,
dadurch **gekennzeichnet,** daß
die Klemmeinrichtung (20, 60) im Bereich des unteren Randes des Gehäuses (10) ausgebildet ist.

5. Gehäuse nach zumindest einem der vorangehenden Ansprüche,
dadurch **gekennzeichnet,** daß
das Gehäuse ein Grundgehäuse (12) und zumindest einen Deckel (14, 16) aufweist, und daß die Klemmeinrichtung (20, 60) an dem Grundgehäuse (12) ausgebildet ist.

6. Gehäuse nach zumindest einem der Ansprüche 1 bis 4,
dadurch **gekennzeichnet,** daß
die Klemmeinrichtung (20, 60) an einem zweiten Deckel (16) ausgebildet ist.
